**Europäisches Patentamt**

**European Patent Office**

**Office européen des brevets**

(19)

(11) Veröffentlichungsnummer: **0 098 496**
**A1**

(12) **EUROPÄISCHE PATENTANMELDUNG**

(21) Anmeldenummer: 83106248.4

(22) Anmeldetag: 27.06.83

(51) Int. Cl.³: **H 01 L 29/78**

(30) Priorität: 01.07.82 DE 3224642

(43) Veröffentlichungstag der Anmeldung: 18.01.84
Patentblatt 84/3

(84) Benannte Vertragsstaaten: **CH DE FR GB IT LI**

(71) Anmelder: **SIEMENS AKTIENGESELLSCHAFT, Berlin und München Wittelsbacherplatz 2, D-8000 München 2 (DE)**

(72) Erfinder: **Strack, Helmut, Dr. phil., Speyerer Strasse 6, D-8000 München 40 (DE)**
Erfinder: **Tihanyi, Jenö, Dr. Ing., Wolfratshauser Strasse 179 b, D-8000 München 71 (DE)**

(54) **IGFET mit Injektorzone.**

(57) Der Durchlaßwiderstand $R_{on}$ von für hohe Sperrspannungen ausgelegten Leistungs-MOSFET ist relativ hoch. Er läßt sich durch eine im Substrat angeordnete Injektorzone (11) herabsetzen, die an eine externe Stromquelle anschließbar ist. Die Injektorzone ist Bestandteil eines Bipolartransistors (B), der über die Gateelektrode (10) des FET mit steigender Gatespannung eingeschaltet wird und Ladungsträger in den Strompfad emittiert. Damit wird quasi die Dotierung des Substrates (2) erhöht und $R_{on}$ verringert.

0098496

SIEMENS AKTIENGESELLSCHAFT          Unser Zeichen
Berlin und München                  VPA  82 P 1 5 1 2 E

IGFET mit Injektorzone

Die Erfindung bezieht sich auf einen IGFET mit einem Halbleitersubstrat vom ersten Leitungstyp, mit mindestens einer planar in die erste Oberfläche des Substrats eingebetteten Kanalzone vom entgegengesetzten Leitungstyp und mit einer in die Kanalzone planar eingebetteten Sourcezone vom ersten Leitungstyp, mit einer an die erste Oberfläche angrenzenden Drainzone, mit einer mit der anderen Substratoberfläche verbundenen Drainelektrode, mit mindestens einer Gateelektrode, die auf einer auf der ersten Oberfläche angeordneten Isolierschicht sitzt, mit mindestens einer in die erste Oberfläche eingebetteten Injektorzone vom entgegengesetzten Leitungstyp, die über einen Kontakt an eine Spannung anschließbar ist.

Ein solcher IGFET ist bereits Gegenstand der älteren deutschen Patentanmeldung P 31 03 444.6. Für hohe Sperrspannungen ausgelegte Leistungs-IGFET der genannten Art haben einen relativ hohen Durchlaßwiderstand $R_{on}$. Der Durchlaßwiderstand wird durch eine im Substrat eingebettete Injektorzone herabgesetzt, die an eine externe Spannungsquelle anschließbar ist. Diese Injektorzone injiziert mit steigender Gatespannung zunehmend Ladungsträger in den den Strompfad bildenden Teil der Drainzone. Dies bewirkt quasi eine Erhöhung der Dotierung der Drainzone, wodurch der Durchlaßwiderstand $R_{on}$ abgesenkt wird.

Die Erfindung bezweckt eine weitere Herabsetzung des Durchlaßwiderstandes.

Hab 1 Dx / 30.06.1982

0098496

Die Erfindung ist dadurch gekennzeichnet, daß in die Injektorzone eine Emitterzone des ersten Leitungstyps eingebettet ist, die höhere Dotierung als die Injektorzone
hat, daß ein an die erste Oberfläche tretendes Teil der
Injektorzone und der zwischen der Kanalzone und der Injektorzone an die erste Oberfläche tretende Teil der
Drainzone von der Gateelektrode bedeckt ist, daß die Injektorzone zumindest an der Oberfläche derart dotiert
ist, daß sich in ihr bei einer den IGFET leitend steuernden Spannung ein die Drainzone und die Emitterzone verbindender Kanal ausbildet.

Weiterbildungen sind Gegenstand der Unteransprüche.

Die Erfindung wird an Hand zweier Ausführungsbeispiele in
Verbindung mit den Fig. 1 bis 3 näher erläutert. Es zeigen:

Fig. 1 den Schnitt durch ein erstes Ausführungsbeispiel,
Fig. 2 den Schnitt durch ein zweites Ausführungsbeispiel
       und
Fig. 3 die Aufsicht auf eine integrierte Halbleiteranordnung mit einer Vielzahl von rasterartig angeordneten IGFET und Injektorzonen gemäß dem Ausführungsbeispiel nach Fig. 2.

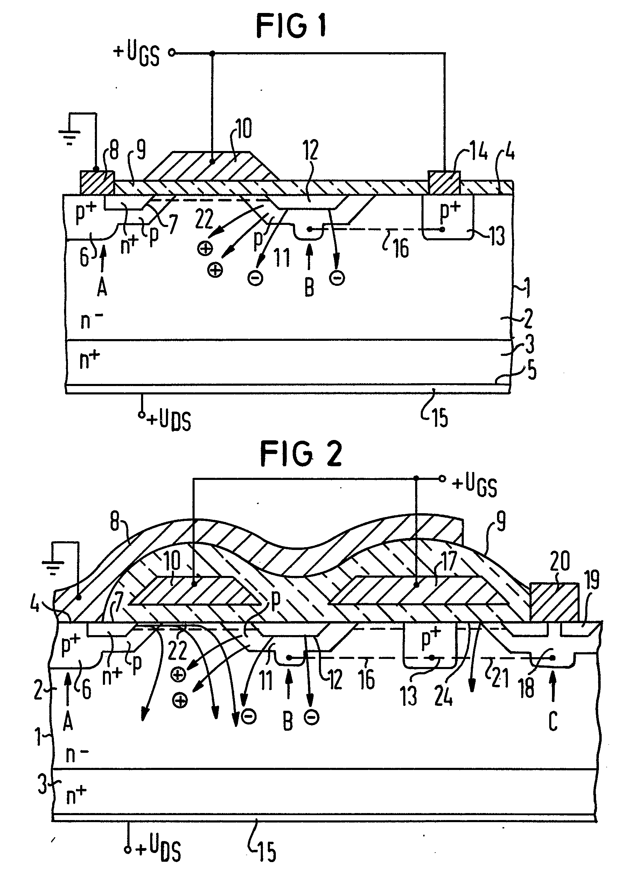

Der IGFET nach Fig. 1 ist auf einem Substrat 1 aufgebaut,
das eine niedrigdotierte Zone 2 und eine vergleichsweise
hochdotierte Zone 3 aufweist. Die Zone 2 dient als Drainzone für den IGFET. In die erste Oberfläche 4 ist eine
Kanalzone vom entgegengesetzten Leitungstyp (p) planar
eingebettet. In die Kanalzone 6 ist eine relativ hochdotierte Sourcezone 7 vom ersten Leitungstyp ($n^+$) planar
eingebettet. Die Sourcezone 7 und die Kanalzone 6 bilden
zusammen mit der Drainzone 2 einen IGFET A.

Im lateralen Abstand vom IGFET A ist in die erste Oberfläche 4 eine Injektorzone 11 vom dem Substrat entgegensetzten Leitungstyp (p) angeordnet. In die Injektorzone 11 ist eine Emitterzone 12 vom ersten Leitungstyp planar eingebettet. Sie ist vorzugsweise hochdotiert ($n^+$). Weiterhin ist in die erste Oberfläche 4 eine relativ hochdotierte Kontaktzone 13 des entgegengesetzten Leitungstyps eingebettet. Diese besitzt einen lateralen Abstand von der Injektorzone 11, kann jedoch auch direkt mit dieser zusammenhängen.

Die Sourcezone 7 und die Kanalzone 6 ist durch eine beiden Zonen gemeinsame Elektrode 8 kontaktiert. Die Oberfläche 4 des Substrats 1 ist mit einer Isolierschicht 9 bedeckt, auf der eine Gateelektrode 10 angeordnet ist. Die Gateelektrode 10 überdeckt einerseits einen an die Oberfläche 4 tretenden Teil der Kanalzone 6 und andererseits einen an die Oberfläche 4 tretenden Teil der Injektorzone 11. Die Kontaktzone 13 ist mit einer Elektrode 14 versehen, die mit der Gatespannungsquelle $+U_{GS}$ und mit der Gateelektrode 10 oder mit einer gesonderten Spannungsquelle verbunden ist. Die andere Oberfläche 5 des Substrats ist mit einer ohmschen Elektrode 15 kontaktiert. Zwischen der Injektorzone 11 und der Kontaktzone 13 ist eine elektrisch leitende Verbindung 16 eingebaut, die gestrichelt dargestellt ist. Diese kann z. B. durch einen oder mehrere außerhalb der Zeichenebene liegende Stege gleichen Leitungstyps wie die Kontaktzone 13 und die Injektorzone 11 gebildet werden.

Zur Erläuterung der Wirkungsweise sei der IGFET an eine positive Drain-Source-Spannung $+U_{DS}$ angeschlossen. Bei Anlegen einer positiven Gatespannung bildet sich unter der Gateelektrode 10 eine Akkumulationschicht 22 und in der Kanalzone 6 an der Oberfläche 4 eine Inversionsschicht aus. Damit fließen negative Ladungsträger aus der Sourcezone 7 in Richtung zur Drainelektrode 15. Ist die Injektorzone 11 zumindest an der Oberfläche 4 niedrig genug dotiert, z. B. so hoch wie die Kanalzone 6, so bildet sich auch an der Oberfläche 4 in der Injektorzone 11 eine Inversionsschicht aus. Damit wird eine leitende Verbindung vom Sourcekontakt 8 zur Emitterzone 12 geschaffen. Da die Injektorzone 11 über die Verbindung 16, die Kontaktzonen 13 und den Kontakt 14 an positivem Potential liegt, verhält sich die aus Emitterzone 12, Injektorzone 11 und Drainzone 2 bestehende Anordnung wie ein Bipolartransistor (B), wobei die Injektorzone 11 die Basiszone bildet. Da der Transistor B durch einen positiven Steuerstrom in die Injektorzone 11 aufgesteuert wird, emittiert er negative Ladungsträger in die Drainzone 2. Die Injektionswirkung nimmt dabei mit steigender Gatespannung wegen des Stromverstärkungsfaktors des Bipolartransistors B einen steilen Verlauf. Die Kante der Injektorzone injiziert außerdem positive Ladungsträger in die Drainzone, was eine entsprechende Konzentrationserhöhung von negativen Ladungsträgern, d. h. eine Quasi-Erhöhung der Dotierung zur Folge hat. Damit wird der Durchlaßwiderstand abgesenkt.

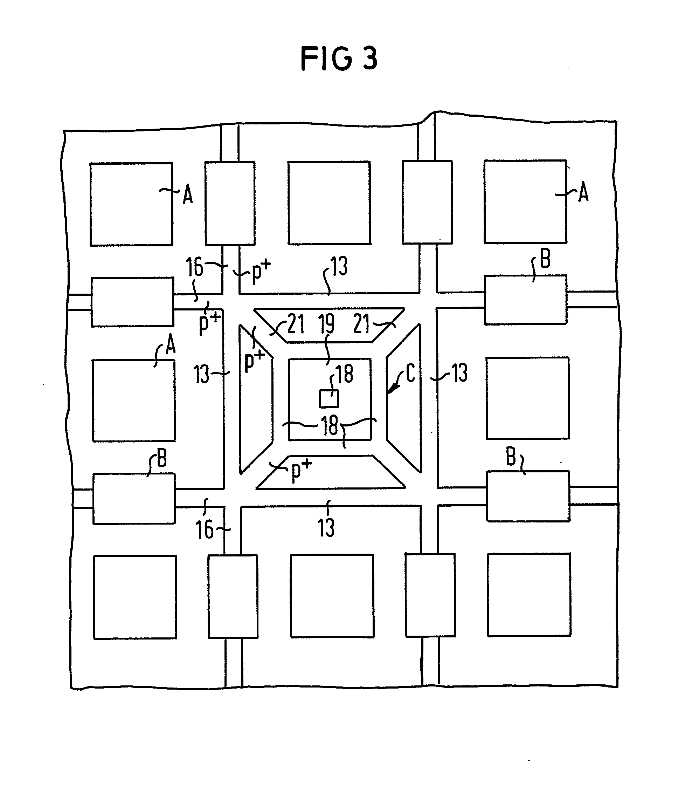

Bei der Anordnung nach Fig. 1 wird die Gatespannungsquelle mit dem Steuerstrom des Bipolartransistors B belastet. Dies ist für manche Zwecke unerwünscht. In Fig. 2 ist eine Anordnung dargestellt, bei der der Steuerstrom für den Bipolartransistor B nicht der Gatespannungsquelle, sondern der Drain-Source-Spannungsquelle entnommen wird. Gleiche oder funktionsgleiche Teile wie in Fig. 1 sind mit gleichen Bezugszeichen versehen.

Zusätzlich zu den bei der Anordnung nach Fig. 1 verwendeten Zonen ist in die Anordnung nach Fig. 2 ein Hilfs-FET C integriert, der eine Kanalzone 18 (p-dotiert) und eine Sourcezone 19 ($n^+$-dotiert) aufweist. Sourcezone 19 und Kanalzone 18 sind durch einen Kontakt 20 elektrisch miteinander verbunden. Dieser Kontakt ist nicht angeschlossen, das Potential des Hilfs-FET C driftet daher zwischen
dem Potential $+U_{DS}$ und Massepotential. Der Hilfs-FET C
weist eine gegen die Oberfläche isolierte Gateelektrode
17 auf, die ein an die Oberfläche tretendes Teil der Kanalzone 18 überdeckt. Die Gateelektrode 17 kann auch die
Kontaktzone 13 und ein an die Oberfläche tretendes Teil
der Injektorzone 11 überdecken. Notwendig ist dies jedoch
nicht. Diese Anordnung bietet jedoch dann einen Vorteil,
wenn die Kanalzonen 6, 18 und die Injektorzone 11 sowie
die Sourcezonen 7, 19 und die Emitterzone 12 mit ein und
demselben Verfahrensschritt hergestellt werden sollen,
z. B. durch Ionenimplantation. Hierzu werden die Gateelektroden 10 und 17 aus n-dotiertem polykristallinem Silicium hergestellt und bilden Implantationsmasken für die
genannten Zonen. Die Gateelektroden 10 und 17 sind zweckmäßigerweise elektrisch miteinander verbunden oder bilden
eine einzige Gateelektrode.

Beim Anlegen einer positiven Gate-Source-Spannung öffnet
der IGFET A und es fließen negative Ladungsträger zur
Drainelektrode 15. Gleichzeitig wird wie in Verbindung
mit Fig. 1 beschrieben die Emitterzone 12 elektrisch mit
dem Sourcekontakt 8 verbunden. Gleichzeitig mit dem Leitendwerden des IGFET A wird unter Ausbilden einer Akkumulationsschicht 24 und einer entsprechenden Inversionsschicht an der Oberfläche 4 im Bereich der Kanalzone 18
auch der Hilfs-FET C leitend gesteuert. Er emittiert
ebenfalls negative Ladungsträger zur Drainelektrode 15.
Damit kommt eine ohmsche Verbindung zwischen der Drainelektrode 15 und der Sourcezone 19 des Hilfs-FET C zustande. Über den Kontakt 20 liegt damit auch die Kanalzone 18 an positivem Potential. Die Kanalzone 18 ist über
eine ohmsche Verbindung 21, die gestrichelt dargestellt ist, mit der Kontaktzone 13 verbunden. Die ohmsche Verbindung 21 kann ebenso wie die ohmsche Verbindung 16 durch einen außerhalb der Zeichenebene liegenden Steg gleichen Leitungtyps gebildet sein. Über die leitende Verbindung 16 wird dann auch der Bipolartransistor B in seinen leitenden Zustand gesteuert und emittiert, wie in Verbindung mit Fig. 1 beschrieben, negative Ladungsträger. Die Kante der Injektorzone injiziert gleichzeitig positive Ladungsträger in den Strompfad. Damit wird der Durchlaßwiderstand $R_{on}$ des IGFET bedeutend herabgesetzt.

Die Kontaktzone 13 ist für die ohmsche Verbindung zwischen der Kanalzone 18 und der Injektorzone 11 an sich entbehrlich. Sie dient jedoch dazu, den Hilfs-FET C vom IGFET A elektrisch zu entkoppeln, da sich ohne die Kontaktzone 13 an der Oberfläche 4 eine durchgehende Inversionsschicht ausbilden könnte. Damit wäre der Hilfs-FET C dem IGFET A elektrisch parallelgeschaltet. Zur elektrischen Trennung der Akkumulationsschichten 22 und 24 wird die Kontaktzone 13 zwischen dem Bipolartransistor B und dem Hilfs-FET C angeordnet. Sie muß so hoch dotiert sein, daß an ihrer Oberfläche unter der Gateelektrode 17 keine Inversion eintritt. Als Dotierung an der Oberfläche der Kontaktzone 13 kann z. B. $10^{18}$ bis $10^{20}$ Atome $cm^{-3}$ eingestellt werden. Demgegenüber haben die Kanalzone und die Injektorzone an der Oberfläche des Substrats z. B. eine Dotierung von $10^{16}$ bis $10^{17}$ Atome $cm^{-3}$.

Für höhere Ströme empfiehlt es sich, eine integrierte Anordnung mit einer Vielzahl der in Fig. 2 dargestellten Elemente aufzubauen. Eine solche Anordnung ist in Fig. 3 dargestellt. Sie weist mehrere rasterförmig angeordnete IGFET A, mehrere Bipolartransistoren B und beispielsweise einen Hilfs-FET C auf. Zur elektrischen Trennung des Hilfs-FET von den IGFET-Zellen A umgibt die Kontaktzone 13 den Hilfs-FET C in lateralem Abstand allseitig. Die in Fig. 2 gestrichelt dargestellten elektrischen Verbindungen 16 und 21 sind hier als in die Oberfläche eingebettete Stege vom dem Substrat entgegengesetzten Leitungstyp
dargestellt. Für noch höhere Leistungen ist es möglich,
die in Fig. 3 dargestellte Anordnung wiederum rasterartig
vielfach auf einem größeren Substrat anzuordnen.

3 Figuren
7 Patentansprüche

0098496

## Patentansprüche

1. IGFET mit einem Halbleitersubstrat (1) vom ersten Leitungstyp, mit mindestens einer planar in die erste Oberfläche (4) des Substrats eingebetteten Kanalzone (6) vom entgegengesetzten Leitungstyp und mit einer in die Kanalzone planar eingebetteten Sourcezone (7) vom ersten Leitungstyp, mit einer an die erste Oberfläche angrenzenden Drainzone, mit einer mit der anderen Substratoberfläche (5) verbundenen Drainelektrode (15), mit mindestens einer Gateelektrode (10), die auf einer auf der ersten Oberfläche angeordneten Isolierschicht (9) sitzt, mit mindestens einer in die erste Oberfläche eingebetteten Injektorzone (11) vom entgegengesetzten Leitungstyp, die über einen Kontakt an eine Spannung anschließbar ist, d a - d u r c h g e k e n n z e i c h n e t , daß in die Injektorzone (11) eine Emitterzone (12) des ersten Leitungstyps eingebettet ist, die höhere Dotierung als die Injektorzone hat, daß ein an die erste Oberfläche tretendes Teil der Injektorzone (11) und der zwischen der Kanalzone und der Injektorzone an die erste Oberfläche tretende Teil der Drainzone (2) von der Gateelektrode (10) bedeckt ist, daß die Injektorzone zumindest an der Oberfläche derart dotiert ist, daß sich in ihr bei einer den IGFET (A) leitend steuernden Spannung ein die Drainzone (2) und die Emitterzone (12) verbindender Kanal ausbildet.

2. IGFET nach Anspruch 1, d a d u r c h g e k e n n - z e i c h n e t , daß die Injektorzone (11) über eine in die erste Oberfläche planar eingebettete Kontaktzone (13) vom entgegengesetzten Leitungstyp an die Spannung anschließbar ist.

3. IGFET nach Anspruch 2, d a d u r c h g e k e n n - z e i c h n e t , daß die Injektorzone (11) über einen in die erste Oberfläche eingebetteten Steg (16) elektrisch verbunden ist, der gleichen Leitungstyp wie die Injektorzone hat.

4. IGFET nach Anspruch 3, d a d u r c h   g e k e n n - z e i c h n e t ,   daß die Kontaktzone (13) mit der Kanalzone (18) eines im Substrat angeordneten Hilfs-FET (C) elektrisch verbunden ist, dessen Source- und Kanalzone (19, 18) durch einen Kontakt (20) miteinander verbunden ist.

5. IGFET nach Anspruch 4, d a d u r c h   g e k e n n - z e i c h n e t ,   daß die Kontaktzone (13) mit der Kazone (11) des Hilfs-FET elektrisch durch einen in die erste Oberfläche eingebetteten Steg (21) verbunden ist, der gleichen Leitungstyp wie die Kontaktzone hat.

6. IGFET nach Anspruch 4 oder 5, d a d u r c h   g e - k e n n z e i c h n e t ,   daß der Hilfs-FET (C) eine mit dem IGFET (A) gemeinsame Gateelektrode hat und daß die Kontaktzone (13) derart zwischen Hilfs-FET (C) und Injektorzone (11) angeordnet und so hoch dotiert ist, daß eine sich unter der Gateelektrode ausbildende Akkumulationsschicht zwischen Injektorzone und Hilfs-FET vollständig unterbrochen ist.

7. Integrierte Schaltungsanordnung nach einem der Ansprüche 4 bis 6 mit einer Vielzahl von rasterartig auf dem Substrat angeordneten IGFETs, Injektorzonen und Hilfs-FET, d a d u r c h   g e k e n n z e i c h n e t ,   daß jeder Hilfs-FET (C) in lateraler Richtung von einer Kontaktzone (13) umgeben ist.

**FIG 1**

**FIG 2**

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A,P | EP-A-0 057 256 (SIEMENS) <br> * Anspruch 1 * | 1 | H 01 L 29/78 |
| A | US-A-4 145 700 (JAMBOTKAR) <br> * Anspruch 1; Figur 9A * | 1 | |
| A | US-A-4 209 795 (NONAKA) <br> * Ansprüche 1,. 4 * | 1 | |
| A,P | US-A-4 366 495 (GOODMAN) <br> * Spalte 1, Zeilen 38-54; Figur 2 * | 1 | |
| A | EP-A-0 043 009 (SIEMENS) <br> * Anspruch 1; Seite 5, Zeilen 3-25; Figur 2 * | 1 | |
| A | DE-A-3 114 970 (SUPERTEX) <br> * Anspruch 1; Seiten 12, 22-24; Figuren 10, 10A, 11 * | 1 | RECHERCHIERTE SACHGEBIETE (Int. Cl. ³) <br><br> H 01 L 29/78 <br> H 01 L 27/02 |
| A | GB-A-2 072 422 (RCA) <br> * Seite 1, Zeilen 39-70 * | 1 | |

Der vorliegende Recherchenbericht wurde für alle Patentansprüche erstellt.

| Recherchenort <br> BERLIN | Abschlußdatum der Recherche <br> 27-09-1983 | Prüfer <br> ROTHER A H J |
|---|---|---|